# EUROPEAN PATENT APPLICATION

(11) **EP 4 019 672 A1**
(43) Date of publication of application: **29.06.2022**
(21) Application number: 20867543.9
(22) Date of filing: 15.09.2020
(51) Int. Cl.: C30B 25/20, C30B 25/18

(54) **MANUFACTURING METHOD FOR MONOCRYSTALLINE SILICON SHEET**

(30) Priority: 25.09.2019 CN 201910909721
(71) Applicant: Ding, Xin, Shanghai 200123 (CN)
(72) Inventor: Ding, Xin, Shanghai 200123 (CN)
(74) Representative: FARAGO Patentanwaltsgesellschaft mbH
(86) International application number: PCT/CN2020/115225
(87) International publication number: WO 2021/057542

(57) **Abstract**

The present application provides a method for manufacturing a monocrystalline silicon sheet, including: cutting a monocrystalline silicon rod along a radial or an axial direction of the monocrystalline silicon rod to obtain a monocrystalline silicon substrate; etching a porous silicon structure on a top surface and a bottom surface of the monocrystalline silicon substrate by wet etching; depositing a monocrystalline silicon thin layer on the porous silicon structure by chemical vapor deposition, so that a thickness of the monocrystalline silicon thin layer reaches a predetermined value; and striping the monocrystalline silicon thin layer from the porous silicon structure to obtain the monocrystalline silicon sheet. In the present application, the production capacity of directly manufacturing a single crystal silicon wafer by a chemical vapor deposition method can be improved, and a process for manufacturing a silicon wafer is combined with the process of a diffusion emitter conventionally belonging to cell manufacturing, so that a manufacturing cost of a solar monocrystalline silicon cell is significantly reduced.

## Description

### Technical field

The present invention relates to monocrystalline silicon wafer manufacturing, and specifically, to a method for manufacturing a monocrystalline silicon sheet that can be used in a solar cell.

### Background

A single crystal of silicon is a crystal having a substantially complete lattice structure. The monocrystalline silicon has different properties in different directions and is a good semiconducting material. The monocrystalline silicon is made by melting and pulling a high-purity polycrystalline silicon in a Czochralski or float-zone monocrystalline furnace, and a crystal rod made by pulling is cut into silicon wafers by a band saw or a wire saw slicer. In recent years, a case in which monocrystalline silicon ingots are casted by using an ingot casting method has also appeared, the crystal quality of the monocrystalline silicon ingots made by the method is lower than that of the monocrystalline silicon made by the Czochralski or float-zone method, and the monocrystalline silicon ingots are only used in the photovoltaic industry. Monocrystalline silicon wafers are used to manufacture semiconductor devices, solar cells, and the like.

The technical scheme of the conventional monocrystalline silicon wafer technology is as follows:
Firstly, about 98% of metal silicon (impurities are mainly aluminum, iron, calcium, and the like) is obtained by smelting and reducing quartz sand (compositions are mainly silicon dioxide and impurities) and coke in an electric furnace.
Secondly, a high-purity halosilane, usually trichlorosilane, silicon tetrachloride, two-way dihydrogen silicon, or hexachlorosilane, is obtained by chemical purification by reacting metal silicon with a halogen compound. Silane is further obtained by reverse disproportionation.

Then, the high-purity trichlorosilane, or silane, or the like, is introduced as a precursor into a reaction device such as a reduction furnace or a fluidized bed. The reduction furnace can produce pairs of silicon rods, and the fluidized bed can produce spherical granular silicon.

Further, the broken silicon rod or granular silicon is filled into a quartz crucible, and a monocrystalline silicon rod is prepared by the Czochralski method (also referred to as the CZ method) or the float-zone method (FZ method), or a monocrystalline silicon ingot or polycrystalline silicon ingot is produced by the ingot casting method.

Finally, side walls, and the head and tail of the silicon ingot or silicon rod are stripped, and the stripped silicon ingot or silicon rod is squared, and then is cut into silicon wafers by using a band saw or wire saw.

Generally speaking, side walls, and the head and tail of the silicon ingot or silicon rod are stripped, and the stripped silicon ingot or silicon rod is squared, and then a large amount of scrap materials are produced. When a band saw or a wire saw performs cutting to obtain silicon wafers, because both the blade of the band saw and the steel wire of the wire saw have a certain thickness, the silicon ingot or silicon rod contacted by the blade and the steel wire are mechanically pulverized and then enters the cutting fluid, and this is called a cutting edge loss or a cutting loss. In the current solar silicon wafer technology, a thickness of the silicon wafer is 150-180 microns, and the cutting edge loss is between 80 microns, and may be advanced to the cutting edge loss of only 50 microns in the near future. These scrap materials and the cutting edge loss total up to about 50%, that is, only 50% of the high-purity polycrystalline silicon raw materials become silicon wafers. The reduction process of the polycrystalline silicon raw materials is a process under a high temperature of more than 1,000 degrees Celsius (a silane fluidized bed method is a process at a temperature of slightly lower than 600-800 degrees Celsius), and the pulling crystal needs to melt the silicon material and heat the silicon material to more than 1,400 degrees. Therefore, a self-contained power plant is commonly constructed in China's polycrystalline silicon raw material plants and monocrystalline silicon plants, or the polycrystalline silicon raw material plants and monocrystalline silicon plants are relocated to a pit power plant at a low power price, such as Neimeng and Xinjiang (this indicates that the power plant is constructed at a pit port of a coal mine to avoid the cost of coal transportation). The direct power supply of the power plant is used to save the power supply fee of the power grid or areas with abundant hydroelectric power use low-cost hydroelectric power during wet seasons to reduce the cost of electricity produced. In addition, quartz crucibles, graphite crucibles, graphite heaters, and steel wires for wire saws are all consumables for single crystal pulling, and consequently a large cost is caused.

### Summary

The present application provides a high-productivity, low-cost technology for obtaining monocrystalline silicon wafers by chemical vapor deposition by directly using silane or halosilane precursors without using a conventional method in which a high-purity polycrystalline silicon is used to be melt to prepare crystals and cut the crystals.

According to a first aspect, an embodiment of the present application provides a method for manufacturing a monocrystalline silicon sheet, including:
cutting a monocrystalline silicon rod along a radial or an axial direction of the monocrystalline silicon rod to obtain a monocrystalline silicon substrate;
etching a porous silicon structure on a top surface and a bottom surface of the monocrystalline silicon substrate by wet etching;
depositing a monocrystalline silicon thin layer on the porous silicon structure by chemical vapor deposition, so that a thickness of the monocrystalline silicon thin layer reaches a predetermined value; and
striping the monocrystalline silicon thin layer from the porous silicon structure to obtain the monocrystalline silicon sheet.

In some implementations, the etching a porous silicon structure on a top surface and a bottom surface of the monocrystalline silicon substrate by wet etching further includes: disposing a pair of negative electrodes on the top surface and the bottom surface of the monocrystalline silicon substrate, respectively, applying a current, and etching the porous silicon structure on the top surface and the bottom surface.

In some implementations, the depositing a monocrystalline silicon thin layer on the porous silicon structure by chemical vapor deposition further includes: disposing the monocrystalline silicon substrate on a bracket in a reaction chamber for the chemical vapor deposition, heating the monocrystalline silicon substrate, and introducing a precursor gas into the reaction chamber, to make the precursor gas contact the porous silicon structure on the top surface and the bottom surface, so that the monocrystalline silicon thin layer is deposited on the porous silicon structure.

In some implementations, the striping the monocrystalline silicon thin layer from the porous silicon structure to obtain the monocrystalline silicon sheet further includes:
before striping the monocrystalline silicon thin layer, truncating the monocrystalline silicon thin layer to the porous silicon structure according to a required size of the monocrystalline silicon sheet, and striping the truncated monocrystalline silicon thin layer to obtain the monocrystalline silicon sheet; or
striping the monocrystalline silicon thin layer from the porous silicon structure, and truncating the striped monocrystalline silicon thin layer according to a required size of the monocrystalline silicon sheet, to obtain the monocrystalline silicon sheet.

In some implementations, before striping the monocrystalline silicon thin layer, the method further includes: placing the monocrystalline silicon substrate into a solar cell processing device, wherein the monocrystalline silicon thin layer is deposited on the top surface and the bottom surface of the monocrystalline silicon substrate, and performing a single-side preparation process of a solar cell on each of the monocrystalline silicon thin layers.

In some implementations, the method further includes: when the chemical vapor deposition is performed, collecting a tail gas from a chemical vapor deposition reaction, wherein the tail gas comprises a precursor gas and a dopant gas that do not participate in the reaction, and a by-product gas of the reaction;
separating the collected tail gas by using a separation apparatus to obtain the precursor gas that does not participate in the reaction and the by-product gas of the reaction; and
applying the precursor gas that does not participate in the reaction obtained from separation to the chemical vapor deposition, and/or applying the precursor gas synthesized by using the by-product gas obtained from separation as a raw material to the chemical vapor deposition.

In some implementations, the method further includes: after striping the monocrystalline silicon thin layer from the porous silicon structure, etching the porous silicon structure on the top surface and the bottom surface of the monocrystalline silicon substrate by wet etching;
depositing a monocrystalline silicon thin layer on the porous silicon structure by chemical vapor deposition, so that a thickness of the monocrystalline silicon thin layer reaches a predetermined value; and
striping the monocrystalline silicon thin layer from the porous silicon structure to obtain the monocrystalline silicon sheet.

In some implementations, the method further includes: when a thickness of the monocrystalline silicon substrate drops to a lower threshold, increasing the thickness of the monocrystalline silicon substrate by stopping etching the porous silicon structure and depositing the monocrystalline silicon thin layer on the crystalline silicon substrate.

In some implementations, the monocrystalline silicon thin layer has a width of 50 mm to 500 mm, a length of 50 mm to 5 m, and a thickness of 10µm to 10 mm.

Compared with the prior art, main differences and effects of the implementations of the present application are as follows:
According to the implementations of the present application, the productivity of directly producing a monocrystalline silicon wafer by the chemical vapor deposition method can be improved, and a process for manufacturing a silicon wafer is combined with a process of a diffusion emitter conventionally belonging to cell production, so that the manufacturing cost of a solar monocrystalline silicon cell is significantly reduced. For example:
1. A monocrystalline silicon thin-film silicon wafer is simultaneously deposited on both sides on the monocrystalline silicon substrate, the capacity of the chemical vapor deposition device is doubled, and equipment investment costs are reduced by half.
2. Porous silicon is simultaneously etched on both sides on the monocrystalline silicon substrate, and the production costs of the porous silicon are reduced by half.
3. A monocrystalline silicon rod is cut, and a rectangular double-sided monocrystalline silicon substrate is used, to obtain a monocrystalline silicon cell of silicon wafers having an area larger than the current 156-mm, 166-mm square silicon wafers or even larger than 210-mm square silicon wafers, such as 166mm × 4200mm. Because the cost of silicon wafers and cells has been reduced rapidly, and the cost of glass of the panel of the assembly has changed slowly, many technologies have been developed to reduce the cost of the assembly by sacrificing the cost of the silicon wafer cells to increase the power of the assembly. Silicon wafers having a larger area are expected to help reduce the cost of the process part of the cell manufacturing assembly.
4. In a case of double-sided deposition, a design without a graphite susceptor (or referred to as a carrier plate) is used. The amortization cost of each graphite susceptor of $1.3 is reduced. It ensures that the operating expense of a method for directly obtaining a silicon wafer by the chemical vapor deposition is lower than that of the technical route of polycrystalline material + crystal growth + slicing.
5. The monocrystalline silicon wafer is not striped from the monocrystalline silicon substrate on which the monocrystalline silicon thin film is deposited, and the polycrystalline silicon substrate integrally enters a cell device for a cell process. The two-step process of depositing the back mask and removing the mask can be omitted, so that the investment and cost of cell production can be reduced by about 10%.
6. An epitaxy emitter is further made by in-situ chemical vapor deposition, so that the investment in the cell device can be further reduced.
7. The investment of cleaning equipment for removing the cutting damage is reduced.
8. Porous silicon is used as the backside light trapping structure, so that the cell efficiency is further improved.
9. The tail gas from chemical vapor deposition device is separated, purified and recycled, so that the cost can be reduced by 10%-17%.
10. The chemical vapor deposition method is used to recycle the thinned substrate after the porous silicon is etched, so that the cost is further reduced by about 2.8-5.1%.

### Brief description of drawings

FIG. 1 is a schematic diagram of a monocrystalline silicon substrate on which a porous silicon structure is etched on both sides, and on which a monocrystalline silicon thin film is deposited by chemical vapor deposition.
FIG. 2 is a schematic diagram of obtaining a regular square monocrystalline silicon substrate and obtaining a rectangular monocrystalline silicon substrate by cutting by using a monocrystalline silicon rod obtained by a Czochralski method.
FIG. 3 is a schematic diagram of the electrical and equipment for simultaneously etching porous silicon on both sides on a monocrystalline silicon substrate by using an electrolyte based on hydrofluoric acid.
FIG. 4 is a schematic diagram of the electrical and equipment for simultaneously etching porous silicon on both sides on a monocrystalline silicon substrate in an in-line continuous manner by using an electrolyte based on hydrofluoric acid.
FIG. 5 is a schematic diagram of a chemical vapor deposition device for double-sided deposition of a monocrystalline silicon thin film on a monocrystalline silicon substrate without a susceptor/carrier used in the present application.
FIG. 6 is a cross sectional schematic view of an N-type TOPCON high-efficiency solar cell in which when a single-crystal silicon thin film structure is grown on double-sided porous silicon, the process of making a mask and removing the mask is omitted, the stripping and the process of making a backside are not performed.
FIG. 7 is a block flow diagram BFD for separation and recycling of tail gas from a chemical vapor deposition device.
FIG. 8 is a block flow diagram BFD of one embodiment starting from substrate preparation, performing fabrication of porous silicon, deposition of monocrystalline silicon, partial cell front-side process, closed-loop utilization of precursors, and ending by recycling of substrates.

### Detailed description of embodiments

In order to make objectives and technical solutions of the embodiments of the present application more clear, the technical solutions of the embodiments of the present application are described clearly and completely below with reference to the accompanying drawings of the embodiments of the present application. Obviously, the described embodiments are some, but not all, embodiments of the present application. Based on the described embodiments of the present application, all other embodiments obtained by a person of ordinary skill in the art without creative efforts fall within the scope of protection of the present application.

According to an embodiment of the present application, a method for manufacturing a monocrystalline silicon sheet, including:
cutting a monocrystalline silicon rod along a radial or an axial direction of the monocrystalline silicon rod, to obtain a monocrystalline silicon substrate;
etching a porous silicon structure on a top surface and a bottom surface of the monocrystalline silicon substrate by wet etching;
depositing the monocrystalline silicon thin layer on the porous silicon structure by chemical vapor deposition, so that a thickness of the monocrystalline silicon thin layer reaches a predetermined value; and
stripping the monocrystalline silicon thin layer from the porous silicon structure to obtain a monocrystalline silicon sheet.

The above implementations are described in detail below with reference to the accompanying drawings. In the drawings, 001 is a deposited monocrystalline silicon thin film, 002 is a porous silicon layer, 003 is a monocrystalline silicon substrate, 003A is a common regular square monocrystalline silicon substrate, and 003B is a rectangle monocrystalline silicon substrate, 004 is a monocrystalline silicon rod, 101 is a platinum electrode, 102 is a positive electrode of a power supply, 103 is an electrolytic cell, 104 is an electrolyte, 105 is a reaction chamber, 106 is an infrared heater or an induction coil heater, 107 is the inlet of the reaction chamber, 108 is the exhaust of the reaction chamber.

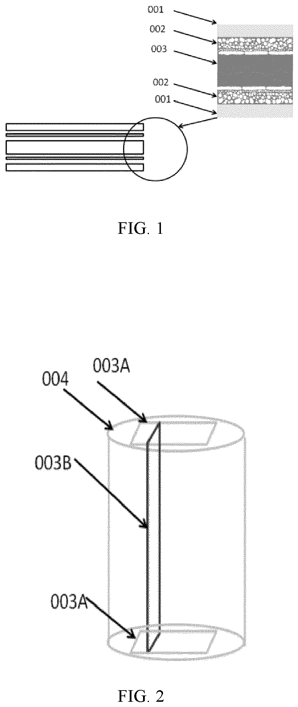

FIG. 1 is a schematic diagram of etching a porous silicon structure on a top surface and a bottom surface of a monocrystalline silicon substrate. As shown in FIG. 1, for a monocrystalline silicon substrate 003, a double-sided porous silicon layer 002 is prepared on the front side and the back side of the monocrystalline silicon substrate 003 by using an electrochemical method, and a monocrystalline silicon thin film is simultaneously prepared on both sides on the double-sided porous silicon layer 200 by a chemical vapor deposition method. After the pores of the porous silicon 002 are closed, a monocrystalline silicon thin film of a sufficient thickness is grown on the porous silicon, and the monocrystalline silicon thin film is taken away from the sparsest part of the porous silicon having the highest porosity rate by means of a vacuum suction cup, wedge insertion, or the like, and even laser cutting is supplemented to speed up the process. Because this process is generally taking away from the substrate, the process is often referred to as striping.

FIG. 2 is a schematic diagram of cutting a monocrystalline silicon rod along a radial or an axial direction of a monocrystalline silicon rod to obtain a monocrystalline silicon substrate. FIG. 2 is two specific implementations for preparing the monocrystalline silicon substrate 003. 003A is obtained by cutting along a circumferential direction of the monocrystalline silicon (Czochralski or float-zone) rod. A monocrystalline silicon substrate of the common 156mm, 166mm square silicon wafer can be produced by this method. The 156mm, 166mm square monocrystalline silicon thin film can be directly obtained after making porous silicon and depositing the monocrystalline silicon, that is, a common square monocrystalline silicon wafer is obtained. 003B is a rectangular monocrystalline silicon substrate obtained by cutting along a long axis of the monocrystalline silicon rod. A large (rectangular) silicon wafer having an area larger than the 210×210mm square wafer of the so-called M12 can be produced by this method. If a square silicon wafer is required, the rectangular monocrystalline silicon thin film can be striped from the substrate and then cut into a plurality of square wafers, or the monocrystalline silicon thin film can be truncated into porous silicon and then striped into a plurality of square wafers.

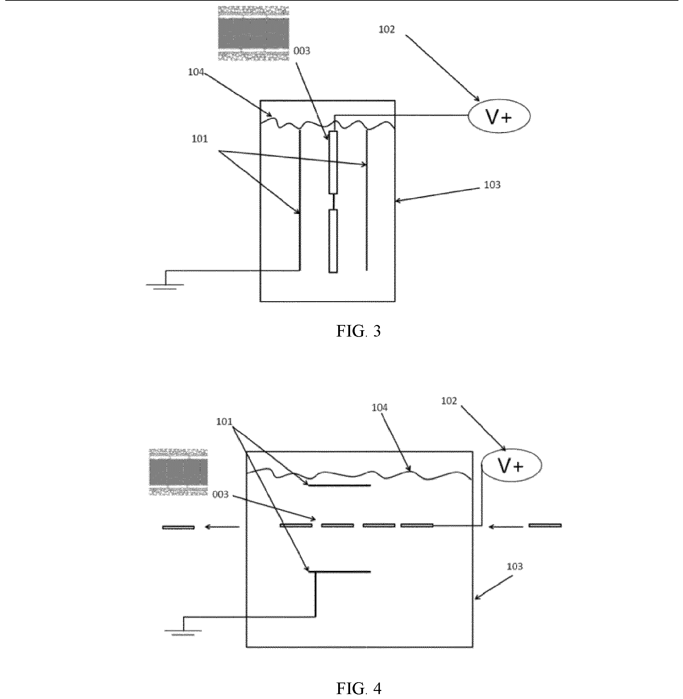

FIG. 3 is a specific implementation of making porous silicon on both sides on a monocrystalline silicon substrate. 003 is a monocrystalline substrate, 101 is a pair of symmetrically arranged platinum electrodes, 102 is a positive electrode of a power supply, 103 is an electrolytic cell, and 104 is an electrolyte for etching porous silicon. Generally speaking, the platinum electrode needs to be constructed into a plane parallel to the monocrystalline silicon substrate with the same size as the substrate by winding or the like, so as to form a parallel uniform current, so that the prepared monocrystalline silicon substrate has good uniformity. Due to symmetry, this method can make symmetrical porous silicon layers on both the front side and the back side of the substrate, and the symmetrical porous silicon layers serve as starting surfaces for subsequent chemical vapor deposition.

FIG. 4 is a specific implementation of making porous silicon on both sides on a monocrystalline silicon substrate by using an in-line constant-speed continuous production method. 003 is a monocrystalline substrate, 101 is a pair of symmetrically arranged platinum electrodes, 102 is a positive electrode of a power supply, 103 is an electrolytic cell, and 104 is an electrolyte for etching porous silicon. The attached drawing is a side view, that is, the substrate is placed horizontally, and the electrodes are placed up and down. The in-line constant-speed continuous production method can also be designed in the following manner: the substrate is placed vertically, and the electrodes are arranged left and right, that is, FIG. 4 can be regarded as a top view. The substrate enters the electrolyzer at a constant speed from one side and leaves from the other side, and the porous silicon is continuously and simultaneously etched on both sides of the substrate. Due to the space-time symmetry, in some implementations, a parallel electrode as large as the substrate can be used, or a platinum wire can be simply used as one or more wire electrodes, the platinum wire is parallel to the substrate, provided that the direction of the platinum wire is perpendicular to the direction in which the substrate moves forward. The substrate can be moved forward at a constant speed by using a roller or a linear motor.

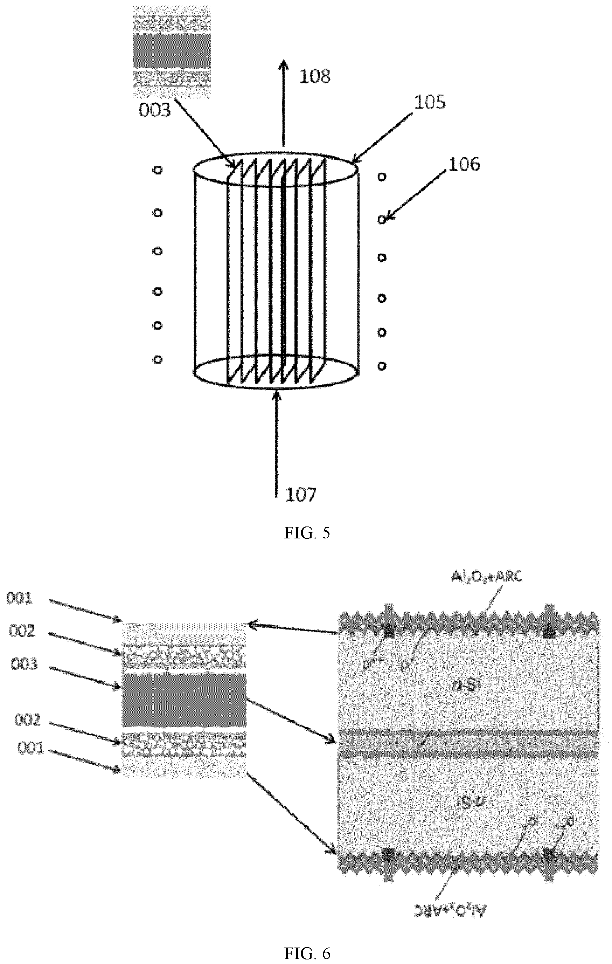

FIG. 5 is an embodiment of a chemical vapor deposition device for double-sided deposition of a monocrystalline silicon thin film on a monocrystalline silicon substrate without a susceptor/carrier used in the present application. The substrate 003 is loaded into the reaction chamber 105, the material of the reaction chamber is preferably quartz, and 106 is an infrared heater or an induction coil to heat the substrate 003 through the reaction chamber. 107 is the precursor inlet of the reaction chamber, and the reaction starts after the precursor is introduced, and 108 is the precursor outlet of the reaction chamber. In some implementations, because the substrate can be placed on a bracket commonly referred to as a wafer boat, the wafer boat does not block one side of the substrate from contacting the precursor like a graphite susceptor or carrier plate, chemical vapor deposition occurs on both sides of the substrate, so that double-sided deposition is implemented, and two monocrystalline silicon wafers are simultaneously fabricated on the front and back sides of one substrate. Precursor gases can be such as silicon-containing halides (halosilanes) silicon tetrachloride, trichlorosilane, dichlorodihydrosilane, silicon hexachloride or silane, disilane and hydrogen.

When epitaxy growth occurs on a machine, the dopant gas is introduced at the same time, so that the in-situ epitaxy emitter can be implemented. In this implementation, the machine can be further designed as an inline epitaxy furnace in which the substrate runs continuously and at a constant speed, and the wafer boat loaded with the substrate is transported to the other side along the reaction chamber, so that the uniformity of film thickness and resistance can be improved in the advancing direction. The two sides of the reaction chamber need to be isolated by means of an air knife. The drawing of this embodiment shows a vertical reaction chamber. Because a space for silicon wafers to enter and leave is required at both ends in the inline design, the inline method of this embodiment is more inclined to use a horizontal reaction chamber design. In addition, a vertical design makes the device too tall and large. The substrate moves in the horizontal direction.

In addition, the drawing shows an embodiment of a rectangular substrate, and therefore long sides of the substrate can only be placed along a direction of an axis of the reaction chamber. When a square substrate is used, in this embodiment, the substrate can be placed perpendicular to a direction of an axis of the reaction chamber, that is, the square substrate is on a circular section of the reaction chamber. Due to gravity and the requirement that no graphite susceptor or carrier plate can be present to block the reaction precursor, the shape of the wafer boat designed to hold the silicon wafer in the vertical reaction chamber becomes rather cumbersome, and the back surface is still blocked. Therefore, the placement method is more suitable for the reaction chamber to be placed horizontally and the substrate to stand upright on the wafer boat.

As an example, if one reaction chamber is filled with six 156mm×954mm rectangular substrates, one reaction chamber can produce 6^{∗}(954mm/156mm)^{∗}2=72 156mm silicon wafers, and then six reaction chambers can be loaded with (produce) 432 wafers, in accordance with the measurement of nearly 500 wafers in one time. Such a system, without a graphite susceptor, can achieve a construction cost of less than 10 million yuan or less, or even a construction cost of only 5 million yuan. In this embodiment, instead of using the inline continuous advancing method, the substrates can be filled intermediately at one time, and all the wafers are taken out after the reaction is completed.

FIG. 6 is a specific embodiment in which the backside diffusion emitter mask in the solar cell is omitted in the present application. The substrate after double-sided deposition is directly textured and then diffused, that is, the P+ part in the figure is formed, and a two-step process of making a backside mask and removing the backside mask is omitted. Further, boron is directly doped in the chemical vapor deposition device of the present application, and the epitaxy emitter, that is, the P+ part in the figure, is fabricated in situ, and is stripped after texturing is performed. The process of making the backside is such as TOPCON, annealing, front-side passivation, and metallization. The three-step process of making the backside mask, boron diffusion, and removing the backside mask is eliminated.

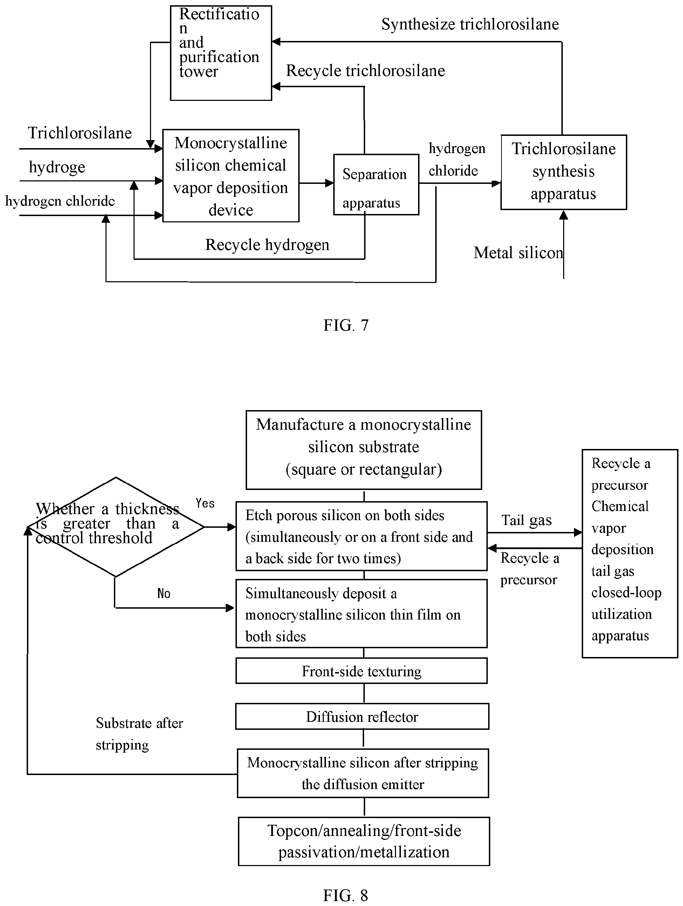

FIG. 7 is a process block flow diagram of one embodiment of closed loop utilization of unreacted precursors and reaction-generated by-products. In the reaction of the chemical vapor deposition method SiCl3H(g) + H2(g) <--> Si(s) + 3HCl(g), the tail gas mainly includes unreacted SiCl3H and H2, as well as the by-product HCl and other halosilanes such as SiH2Cl2, SiCl4 and so on. The tail gas is collected and separated. After rectification and purification, trichlorosilane is returned to the reaction chamber as a raw material, H2 is also returned to the reaction chamber as a raw material, and HCl can be purified and recycled as a raw material for cleaning the reaction chamber. If trichlorosilane is insufficient, HCl can react with silicon Si+3HCl-->SiCl3H+H2 to synthesize trichlorosilane, and trichlorosilane is used as a raw material after rectification and purification. The preparation of trichlorosilane from silicon and hydrogen chloride is an exothermic reaction using a copper catalyst, and is a mature technology commonly used in the industry to synthesize trichlorosilane. Due to numerous reaction by-products, numerous other halosilanes are not identified in this simplified BFD.

FIG. 8 is a flowchart of a specific embodiment of an N-type TOPCON cell. Referring to FIGS. 6 and 8, the following factors are considered: N-type cells have a longer minority carrier lifetime and higher cell efficiency, it is difficult to produce an N-type monocrystalline silicon rod by crystal pulling, and the technical route of the present application has a great advantage over producing the monocrystalline silicon rod by crystal pulling. If the chemical vapor deposition in-situ emitter is used, there is a need to change the process and develop a new front passivation layer, which is technically variable. Therefore, the boron diffusion emitter is still used, and the process of making a backside mask and removing the backside mask is omitted. At the same time, the monocrystalline silicon substrate is recycled, and the lost thickness of the substrate is repaired by using chemical vapor deposition. In addition, according to the specific embodiment of FIG. 7, all available equipment tail gases, that is, unreacted precursors and reaction by-products are used in the closed loop.

The manufacturing technology of monocrystalline silicon wafers is described in detail below. For the manufacture of monocrystalline silicon wafers, a more direct and technically feasible approach is as follows: steps of polycrystalline silicon raw material manufacturing, crystal growth (single crystal pulling or ingot casting) and slicing are skipped, and high-purity silicon-containing precursors (mainly halosilanes (silicon-containing halides) and silanes) are directly used to grow monocrystalline thin films by chemical vapor deposition, which is commonly used in the semiconductor industry, to obtain low-cost, high-quality monocrystalline silicon wafers. This approach is becoming more and more technically feasible under the trend that solar silicon wafers become thinner (the thickness of the solar silicon wafer is already less than or equal to 180 microns in mainstream factories). A representative reaction is to use trichlorosilane and hydrogen as precursors to react to generate silicon and by-product vapor-phase hydrogen chloride, and deposition is performed at a high temperature. The reaction formula is as follows:

SiCl3H(g) + H2(g) <--> Si(s) + 3HCl(g)

In the formula, g represents the vapor phase, and s represents the solid phase.

In addition to reducing the cutting edge loss and the side wall loss, quartz crucibles are used in conventional Czochralski and ingot casting. At a high temperature, the oxygen in the silicon dioxide component of the quartz crucible inevitably enters the silicon crystal with the convection of the silicon liquid, and the boron-oxygen compound formed by oxygen and boron doping reduces the carrier lifetime, which is the main cause of efficiency decline of the current Czochralski single crystal cell. The float-zone single crystal does not contact the quartz crucible during the melting process and have extremely low oxygen content, and has long been the first choice for manufacturing high-efficiency monocrystalline silicon cells. However, the cost of the raw material of the float-zone single crystal is high (mainly a silane method and a Siemens method, low productivity and high cost) and the global output is limited. The float-zone single crystal furnace equipment uses a hard shaft design, which requires higher processing accuracy than the flexible-shaft single crystal furnace used in the Czochralski monocrystalline technology. The price of the float-zone single crystal furnace equipment is in the range of about 10 million to 20 million yuan (1.5 million to 3 million US dollars). Therefore, the float-zone silicon wafer cannot become a common raw material for monocrystalline silicon cells. Vapor deposition directly obtains monocrystalline silicon wafers, the oxygen content of the monocrystalline silicon wafers obtained by vapor deposition can be lower than that of the monocrystalline silicon wafers obtained by Czochralski and ingot casting, and the monocrystalline silicon wafers obtained by vapor deposition can have the same quality as float-zone monocrystalline silicon. Therefore, the direct production of silicon wafers by chemical vapor deposition is expected to further improve the attenuation of monocrystalline silicon cells, and even greatly improve the conversion efficiency of cells. In addition, N-type silicon wafers have always been an important choice for high-efficiency batteries due to higher mobility and longer carrier lifetime. Due to the segregation coefficient of N-type doping, the concentration distribution of the doping in the crystallized single crystal is wider. Therefore, the resistance distribution of the N-type single crystal is wider, and the pulling of N-type single crystal is more difficult than the pulling of the P single crystal, and more costs are needed. Because N-type chemical vapor deposition is vapor-phase doping, the distribution of doping can be better controlled, so that the resistance uniformity of the silicon wafer is better.

However, even so, this is also a huge challenge:
Generally, the costs of industrial products come from two aspects, that is, depreciation and amortization brought by capital investment and operating costs. The operating costs include raw materials, consumables, electricity, and the like. As mentioned above, polycrystalline silicon manufacturing also requires trichlorosilane and hydrogen as precursors, and the cost of this portion is almost equivalent to the corresponding cost of the chemical vapor deposition. The number of consumables such as quartz crucibles, graphite crucibles, graphite heaters, and steel wires of wire saws needed by single crystal pulling is larger than that needed by chemical vapor deposition. The graphite susceptor in the chemical vapor deposition is the main part of the cost amortization, and if this item is removed, the cost of consumables mainly only includes power consumption and precursors, and the two-step process of polycrystalline silicon reduction and single crystal pulling is the process at a temperature of being more than 1000 degrees and having a large amount of heat loss, which is higher than that of the one-step high-temperature process of the chemical vapor deposition. Therefore, silicon wafers can be directly produced by the chemical vapor deposition at the same as or even lower operating cost than the three-step process of polycrystalline silicon + crystal pulling + slicing.

The main challenge comes from the equipment cost of chemical vapor deposition:
1. The growth rate of the mainstream solar Czochralski single crystal furnace is 1.x-2 mm per minute (210 mm-240 mm crystal rod, 156-166 mm square silicon wafer)
2. The growth rate of a reduction furnace for growing polycrystalline silicon is about 1.2-2 mm per hour
3. The growth rate of the commercial chemical vapor deposition device for growing the monocrystalline silicon thin films is about 1-6 microns per minute (some reporting up to 8 microns per minute).

Currently, for the latest polycrystalline silicon material, Czochralski/ingot casting, and slicing, the cost for plant construction is only about 600 million RMB per gigawatt. Calculated as 5-6 watts per 156-mm silicon wafer, the annual output is about 160 million to 200 million monocrystalline silicon wafers. Excluding the silicon-containing halide precursor synthesis factory included in the polycrystalline silicon material factory, the budget that can be allocated to the monocrystalline silicon thin film direct growth factory is about 500 million RMB. Excluding other equipment and factory infrastructure costs, the budget that can be used to invest in chemical vapor deposition device is about 200-300 million RMB

In addition, for the 12-inch chemical vapor deposition epitaxy device for growing a monocrystalline silicon thin film used by the current semiconductor industry (a technology of growing a monocrystalline thin film on a substrate is also referred to as an epitaxy technology, and the corresponding monocrystalline thin film is also referred to as an epitaxy layer), the price of the device ranges from more than 2 million US dollars to 12 million US dollars, and an area of the corresponding silicon wafer deposition region is equivalent to only four to sixteen 156-mm solar silicon wafers. Only a very low productivity in solar silicon wafers is obtained by using such technology. It is assumed that a single monocrystalline silicon thin film vapor deposition device can load 500 wafers at one time, and the deposition rate is 6 microns per minute to produce silicon wafers having a thickness of 150 microns (6 watts per wafer). 1,000 150-micron 156-mm square wafers per hour can be produced, and a single device can produce 8 million wafers per year. Silicon wafers for one gigawatt require 20 chemical vapor deposition devices, and the budget of a cost structure of each device is about 15 million RMB. In this way, the factory investment can be lower than the cost of the conventional technology route of polycrystalline silicon, crystal pulling, and slicing.

**Table 1**

| Device quantity required for per gigawatt for different silicon wafer thicknesses and deposition rates | | | | | |
|---|---|---|---|---|---|
| Silicon wafer thickness | Deposition rate (microns per minute) | Time per furnace | Productivity per hour (wafer) | Year productivity per device | Device quantity per gigawatt |
| 150 | 3 | 60 | 500 | 4000000 | 42 |
| 150 | 6 | 30 | 1000 | 8000000 | 21 |
| 80 | 3 | 30 | 1000 | 8000000 | 21 |
| 80 | 6 | 20 | 1500 | 12000000 | 14 |

The quantity of wafers loaded by per device 500 wafers

Therefore, it is necessary to change the conventional monocrystalline silicon chemical vapor deposition device, and design a chemical vapor deposition device that can perform processing and manufacturing at a low cost and load many silicon wafers at one time for the direct growth of monocrystalline silicon thin films to obtain monocrystalline silicon wafers cheaper than the monocrystalline silicon wafers obtained by the technology route of Siemens-method polycrystalline silicon-Czochralski single crystal -slicing.

In the industry, the elements of a typical silicon monocrystalline chemical vapor deposition (epitaxy) device are as follows:
1. A reaction chamber: The reaction chamber is made of a high-purity and high-temperature-resistant quartz material.
2. A heater: The heater can be an infrared lamp, a resistance heater, or an induction coil disposed outside the transparent reaction chamber.
3. There is a graphite susceptor (tray, or carrier plate) made of a high-purity graphite material in the reaction chamber. The graphite susceptor (tray or carrier plate) is used to receive the silicon wafer and also to receive the heat from the heater, and then the heat is transferred to the silicon wafer by radiation and thermal conduction.
4. A conveying device for reaction precursors conveys the reaction gas into the reaction chamber, and an exhaust device discharges unreacted precursors and reaction by-products.

It should be particularly noted that, for the mainstream or most of the chemical vapor deposition monocrystalline silicon thin film growth (that is, epitaxy) devices in the world, the silicon wafer is placed on a graphite susceptor (tray or carrier plate), and therefore the side of the monocrystalline silicon substrate that contacts the graphite susceptor cannot contact enough precursor for chemical vapor deposition of monocrystalline silicon thin films. The graphite susceptor is usually heated by an infrared lamp, a resistance heater or an induction coil, and the backside of the silicon substrate is heated by thermal conduction by contacting the silicon wafer, which is an important part of heating the substrate. Therefore, the heating method is designed in such a way that deposition on the other side of the substrate cannot be affected. In addition, due to the limitation of the processing method, for the high-purity graphite whose diameter exceeds 32 inches (800 mm), the average price and delivery time increase exponentially, and therefore it is difficult to enlarge the size of the device. In addition, the graphite susceptor is a consumable material and is damaged after long-term use. Therefore, these components not only cause an increase in equipment investment, but also cause a problem of high use cost.

Therefore, in the present application, the graphite susceptor (tray, fixture or carrier plate) is directly removed, so that the double-sided deposition of the monocrystalline silicon substrate is implemented. In the current chemical vapor deposition monocrystalline silicon device for semiconductors, the price of the graphite susceptor is in the range of 800 US dollars-4,000 US dollars. The susceptor with a price of 800 US dollars can carry one 8-inch wafer, which corresponds to one 156-mm square wafer, the susceptor with a price of 2000 US dollars can correspond to four 156-mm square wafers, and the lifespan is usually 30,000 microns, if the thickness of each 156-mm monocrystalline silicon wafer is 80 micrometers, the amortization of the graphite susceptor for each 156-mm silicon wafer is (2000 US dollars / 4) / (30000 micrometers / 80 micrometers) = 1.3 US dollars, which is 3 times the current price of Czochralski monocrystalline silicon wafer (0.45 US dollars) / wafer). From another perspective, for a device with 500 wafers loaded at one time, the investment in a susceptor (carrier plate) is 250,000 US dollars at one time, which is close to 2 million RMB. This is pretty surprising. As analyzed earlier, if the graphite susceptor is cancelled, the main operating costs are only power consumption, precursors, and if the device still uses quartz furnace tubes, quartz furnace tube consumables are included, these operating costs have corresponding items in Czochralski single crystal and polycrystalline silicon material production, so that the operating costs are truly lower than that of the conventional route of polycrystalline silicon + Czochralski + slicing.

The object on which the monocrystalline silicon thin film is grown by chemical vapor deposition in the reaction chamber is the above monocrystalline silicon substrate having a width of (50mm-500mm), a length of (50mm-5m), and a thickness of (10µm-10mm). A porous silicon structure is etched on the front and back sides on the monocrystalline silicon substrate, which is used for growing a monocrystalline silicon thin film and then being striped. The precursors are silicon-containing halides silicon tetrachloride, trichlorosilane, dichlorodihydrosilane, silicon hexachloride or silane, disilane and hydrogen. Very importantly, double-sided deposition on monocrystalline silicon substrates doubles the productivity with almost no increase in equipment investment.

As mentioned earlier, most epitaxy furnaces use a susceptor (or carrier plate) that can withstand the environment of the inner wall of the reaction chamber for indirect heating. The susceptor or carrier plate is usually high-purity graphite or ceramic that can withstand the erosion of silicon-containing halides and hydrohalic acid by-products at high temperatures. The susceptor or the carrier plate cannot generate heat, the susceptor or carrier plate is heated by using a quartz infrared lamp, a graphite heater, a metal resistance heater, an induction coil, or the like, and then the silicon substrate is heated by using the carrier plate or the susceptor. Because the susceptor or carrier plate is usually used to carry a silicon wafer (the monocrystalline silicon substrate in the present application), the susceptor or carrier plate is often close to the backside of the silicon wafer. As a result, the backside of the contacted substrate cannot be coated by using the precursor, and the purpose of growing a monocrystalline silicon thin film on both sides of the present application and simultaneously growing two silicon wafers on the front and back sides to increase productivity cannot be achieved.

Therefore, in the present application, the monocrystalline silicon substrate with both sides unshielded can be directly heated in a non-contact manner such as an infrared lamp, a graphite (carbon) heater, a silicon carbide heater, and an induction coil, instead of being indirectly heated by a susceptor or a carrier plate. These monocrystalline silicon substrates are heated to a maximum of 1410 degrees Celsius. The heater can be a resistance heater, such as electrified graphite, or the like, or may be an infrared lamp, or an induction coil. Because the silicon substrate can be doped in advance, the silicon substrate can be induced by the coil to implement induction heating. When the heater heats the substrate to the process temperature, the precursor flows over the surface of the monocrystalline silicon substrate, and the chemical vapor deposition process begins.

As mentioned earlier, the growth rate of Czochralski single crystal is hundreds of times the growth rate of the chemical vapor deposition monocrystalline silicon, and the deposition rate of polycrystalline silicon is dozens of times the growth rate of the chemical vapor deposition monocrystalline silicon. Therefore, some technical routes have in turn been devoted to growing monocrystalline silicon cells with a dimension of 30-60 micrometers, hoping to reduce the time of monocrystalline silicon deposition by reducing the thickness of the cells. This route is also referred to as monocrystalline silicon thin film cells, which is opposed to polycrystalline silicon thin film cells based on conventional glass or stainless steel. This route encounters a problem that cell efficiency in the dimension of 0-60 micrometer is positively correlated with the thickness, and therefore ultra-thin cells has lower efficiency than current standard cells.

Therefore, from another perspective, if a monocrystalline silicon film is deposited in a manner of having a doubled area in the embodiment of the present application, the cost of monocrystalline silicon wafers of 30-60 microns obtained by deposition on one side in the past can be used to implement monocrystalline silicon wafers of 80-120 microns obtained by double-sided deposition, and a cell of this thickness can be seamlessly compatible with the current mainstream 150-micrometer technology. That is, when this technology is used, it is possible to quickly utilize existing technology for industrialization without driving the cell technology out of the current comfort zone.

In the present application, the chemical vapor deposition monocrystalline silicon device, as the most important process, occupies more than half of the device investment and manufacturing cost in the manufacture of monocrystalline silicon wafers. In contrast, the wet etching device for etching porous silicon has a small investment and large capacity (porous silicon is in a dimension of only a few micrometers, and the speed of electrochemical etching is much higher than that of chemical vapor deposition). Subsequent striping is a common well-known technology, and is usually a simple mechanical striping, which is very low in cost. Therefore, double-sided vapor deposition, which doubles the production capacity of monocrystalline silicon under the same conditions, has important economic and technical value.

Further, the thickness of the monocrystalline silicon film layer deposited on the porous silicon by chemical vapor deposition is 1 micrometer to 1 mm, calculated from the closing of the porous silicon.

Further referring to FIG. 8, after the growth of the monocrystalline silicon film layer deposited on the porous silicon by chemical vapor deposition is completed, the next-step process can be performed. In this case, there are two different options. That is, the monocrystalline silicon film layer on the porous silicon is directly striped off, or not striped off, and the monocrystalline silicon substrate and the monocrystalline silicon film layer deposited on the porous silicon by chemical vapor deposition are sent to the solar cell device of the next-step process. If the device is compatible, the monocrystalline silicon film layer can be stripped after the process steps on one side of the cell are all completed, and then the cell process growth on the other side can be performed.

In the present application, the back side of the monocrystalline silicon wafer refers to the side that contacts the porous silicon structure, and the front side refers to the side grown by chemical vapor deposition, that is, the side opposite to the back side of the silicon wafer, that is, the normal direction of the front side is consistent with the growth direction of chemical vapor deposition. The front side of the cell refers to the light-receiving surface, and generally, an anti-reflection film and a pyramid-shaped light trapping structure are grown on this side to ensure that sunlight enters the cell structure as much as possible.

The advantages of directly going into the cell manufacturing device without stripping are as follows: A small amount of the same coating layers are deposited on the edges and even the backside for many cell coating and diffusion processes, and this is referred to as edge-coating or backside-coating. Generally, the coating on the edges needs to be removed by using an etching process, and a (silicon nitride) film layer is grown on the backside as a hard mask to protect the backside. However, each unstripped monocrystalline silicon thin film silicon wafer and substrate of the double-sided substrate is the hard mask of the silicon wafer opposite to the backside thereof. In this way, the two-step process of growing the hard mask and removing the hard mask can be eliminated.

As in a case of the N-type Topcon cell shown in FIG. 8, after the front-side processes such as front-side texturing and boron diffusion are completed, the stripping can be performed, and then the backside process can be performed. Similarly, both front-side texturing and diffusion benefit from dual processes, that is, the texturing and emitter boron diffusion of two pieces of cells on both front and back sides are completed at the same time, which increases production capacity and reduces costs. In addition, the double-sided simultaneous etching device structure of porous silicon is also suitable for the texturing device. If monocrystalline silicon wafers obtained by depositing on one side of a monocrystalline silicon substrate are manufactured in this method, although the substrate can block the backside coating, because the substrate needs to be recycled, the coating on the back side of the substrate still needs to be removed.

In addition, the porous silicon structure can play the same light trapping effect as texturing, and therefore the porous silicon residue on the back side of the optimized monocrystalline silicon thin film silicon wafer can be directly used as a light trapping structure, and the texturing step is omitted. If the residual porous silicon on the back side of the silicon wafer is used to replace the texturing on the front side of the cell, the substrate and the silicon wafer on the back side cannot be used as a function of a hard mask. Therefore, it is necessary to compare the cost of mask deposition and removal with the cost of texturing, and a process with lower cost and better effect is selected and retained. However, even if the residual porous silicon structure is used as the back side, because wet texturing is continuously used for the front side, a de facto double-sided light trapping structure is formed (texturing on the front side, porous silicon residue on the back side), so that a contribution to conversion efficiency of the cell is also made.

As a variation of the substrate becoming a backside mask, after purging the silicon-containing precursor in the chemical vapor deposition device for growing the monocrystalline silicon, the reaction gas for diffusion can also be used as a boron diffusion device. For example, in the case of N-type topcon cells, front-side boron diffusion usually uses BBr3 and O2, and therefore it is only necessary to increase the BBr3 and O2 piping and apply suitable process control steps.

4 BBr3 + 3 O2 → 2 B2O3 + 6 Br2 2 B2O3 + 3 Si → 4 B + 3 SiO2

Boron trichloride BCl3 and diborane B2H6 are also good sources of boron doping.

At the same time, further, at the last moment of chemical vapor deposition of monocrystalline silicon, boron dopants such as boron trichloride BCl3 and diborane B2H6 are introduced, and boron dopants are introduced into the monocrystalline silicon thin film to directly form an emitter with a sufficient thickness. This approach is technically called an epitaxy emitter, or an in situ doped epitaxy emitter without thermal silicon oxide production, that is, no unwanted boron glass is produced. In this way, the process step of removing the thermal boron oxide glass BSG (borosilicate glass) can be omitted. At the same time, because the backside is blocked by the substrate and the monocrystalline silicon layer on the backside, there is no need to grow a hard mask such as Si3N4 for shielding on the backside, and it is even less necessary to remove the mask by an etching process. In this way, the three-step process of mask growth, boron diffusion, and etching to remove the mask can be omitted. The cost of cell production is greatly reduced. In practice, the epitaxy emitter can be carried out on another machine, or may be a so-called in-situ doped emitter on the same machine. For a diffusion emitter, the depth of the junction is limited by the diffusion of the dopant, and the concentration curve also follows the diffusion equation. The depth of the common solar cell emitter in the literature is mostly 0.3-3 micrometers, and it is difficult to obtain a deep or shallow emitter by the diffusion technology. The epitaxy emitter can be used to make a very deep (thick) emitter, which is not limited by diffusion principles. The concentration (resistance) at different junction depths of the emitter can even be controlled by adjusting the flow rate of the dopant gas. However, if the emitter is made in-situ in the same chemical vapor deposition device, the texturing process is performed after the emitter is completed, and the shape of the emitter is affected.

The above boron diffusion to make the emitter (or boron-doped epitaxy emitter) is for the N-type cell, and for a P-type cell, a phosphorus-doped N+ emitter is required. The principle is the same, the dopant used in the P-type cell is just the opposite to that used in the N-type cell, and the three-step process of mask growth, phosphorus diffusion (for the epitaxy phosphorus emitter only), and etching to remove the mask can be omitted.

In addition, the double-sided process eliminates the processes such as mask growth, phosphorus diffusion (for the epitaxy phosphorus emitter only), and etching to remove the mask. For the non-Topcon process, the double-side process is suitable for PERT, and PERC cells.

In addition, after the wire saw cutting, there is usually a cleaning process in the texturing device to remove the surface damage of the silicon wafer caused by the wire saw. There is often one more step of chemical cleaning before (or after) texturing, and there is one more liquid process tank for the wet process device for texturing. This step can also be omitted for vapor deposition monocrystalline silicon wafers, but is not omitted for a complete machine, and only costs of a liquid process tank and corresponding consumables for the texturing device are saved.

If the final product requires a square silicon wafer or cell wafer, the polycrystalline silicon thin film is truncated to the porous silicon layer according to a required square size before being striped to obtain the square silicon wafer or the cell wafer; or the polycrystalline silicon thin film is stripped to obtain rectangular thin silicon wafers and then are truncated to obtain the square silicon wafer or the cell wafer.

Each 150-micron 156-mm silicon wafer weighs 8.5 grams. Silicon wafers of one gigawatt require 160 to 200 million 156-mm square silicon wafers, weighing 1,360 to 1,700 tons. If trichlorosilane is used as the precursor, the molar weight of silicon is 28, and the molar weight of trichlorosilane is approximately 133.89, losses are ignored, and it is assumed that all trichlorosilane is 100% converted to monocrystalline silicon, at least approximately (133.89/28 ) = 4.75 times, about 6460~8075 tons of trichlorosilane are needed as the precursor. The chlorine in trichlorosilane is converted into 5,000 to 6,000 tons of hydrogen chloride. Considering that only 20-40% of the precursor is deposited as a thin film in an actual epitaxy device, the amount of trichlorosilane introduced into the device is actually 2.5 to 5 times the theoretical value. The treatment of the components of silicon and chlorine in the unreacted precursor also needs to be considered. If the alkali neutralization or combustion treatment the same as that in a conventional cell factory or semiconductor chip factory is performed, tens of thousands of tons of salt water emissions are produced, and for the unreacted silicon, 2,000 to 5,000 tons of silica are correspondingly generated, and need to be landfilled as solid waste or made into white carbon black. Therefore, it is necessary to consider that the tail gas of the chemical vapor deposition device is collected, to be separated and purified as a raw material that is cheaper than the purchased raw material, and environmental emissions are greatly reduced. The precursor is a relatively expensive part of raw materials and a large part of the production cost. From the perspective of the chemical industry, if a 10-GW chemical vapor deposition device monocrystalline silicon wafer factory is built, and the conversion rate is 20%, (6460~8075)/20%^{∗}10=320,000 tons- 400,000 tons of trichlorosilane are needed. Economies of scale of a self-built trichlorosilane synthesis factory and closed-loop recycling of all tail gases of the chemical vapor deposition device have been achieved (see table below).

**Table 2**

| Trichlorosilane gas required for direct production of monocrystalline silicon wafers by chemical vapor deposition for 10 GW | | | | | | |
|---|---|---|---|---|---|---|
| 8.5 | grams per 156-mm silicon wafer | | | | | |
| 6W per 156-mm silicon wafer | 160000000 | wafers per GW | 1360 | tons of silicon/GW | 6460 | tons of trichlorosilane/GW |
| 5W per 156-mm silicon wafer | 200000000 | wafers per gigawatt | 1700 | tons of silicon/GW | 8075 | tons of trichlorosilane/GW |
| | | | | | | |
| if the conversion rate is 20% | 10GW required | | 323000 | tons of trichlorosilane | (in a case of 6W silicon wafer) | |
| | | | 403750 | tons of trichlorosilane | in a case of 6W silicon wafer) | |

In addition, for the chemical vapor deposition device, for example, in the trichlorosilane hydrogen system for monocrystalline silicon deposition, after the reaction temperature, the ratio of trichlorosilane and hydrogen are determined, a higher conversion rate of trichlorosilane often indicates that a higher residence time of the precursor in the reaction chamber results in a decrease in a deposition rate.

According to the growth curve of the Centura HGR machine for 200-mm silicon wafers from Applied Materials, the flow rate of trichlorosilane is decreased from 20SLM to 5SLM, that is, the residence time in the reaction chamber is increased by four times, and the deposition rate is decreased by half from 6.x microns per minute to 3.x microns per minute, that is, 1/4 times the gas flow rate, 1/2 times the deposition rate, and the gas conversion is doubled, but twice times of machines are needed to deposit the films having the same thickness. When the residence time is improved, the gas flow rate may not be improved, but the length of the reaction chamber may be increased in the direction of gas flow. In some cases, the flow of the unreacted precursor to the extension section continues to react to improve the conversion rate. However, part of the precursor in the extension section of the reaction chamber has been consumed, the reaction by-products increase, and the deposition rate decreases. A region having a large area of a low deposition rate appears in the extension section of the reaction chamber, and the low deposition rate is only one-fifth of the deposition rate of the high deposition region at the inlet. These two methods, on the contrary, lead to an increase in the number of chemical vapor deposition devices with higher prices, both of which are very uneconomical choices. The separation device commonly used in the large-scale chemical industry can separate and recycle tens of thousands to hundreds of thousands of tons of precursors at a low cost, and the efficiency and cost are far greater than that of improving the conversion rate of precursors in reactions in chemical vapor deposition device.

Therefore, the pursuit of conversion rate should be abandoned, but a higher deposition rate should be pursued to reduce the number of chemical vapor devices, and to recycle unreacted precursors through a chemical plant to reduce the cost of precursors and the like.

Because silicon wafers or solar plants traditionally do not have the circulating volume of chemicals as large as chemical plants, and regulatory requirements are different from those of trichlorosilane synthesis plants. Therefore, self-built synthesis and/or recycling purification plants for precursors such as trichlorosilane and other gases are often separate entities to meet regulatory requirements in the chemical industry. Therefore, the closed-loop recycling of tail gases of all chemical vapor deposition devices can be in factories of different entities in factories in the same park or in nearby locations. The tail gas collected in the chemical vapor device is transported to the gas (synthesis and/or recycling purification) plant through pipelines or tankers, and the separated and processed gas is sent back. The transportation cost of the tanker increases significantly as the distance increases and the amount of gas used increases. A more reasonable situation is as follows: The silicon wafer factory and the trichlorosilane synthesis and/or recycling purification factory are adjacent to each other, are separated by walls, rivers, roads, or the like, and are independent regulatory entities, and the unused precursors and by-products are connected by pipelines to be recycled, so that the cost and management are optimal.

Therefore, when the monocrystalline silicon is deposited on the porous silicon structure of the monocrystalline silicon substrate by using the chemical vapor deposition method, the tail gas is collected at the tail gas outlet of the chemical vapor deposition device, and components of the tail gas are unreacted precursors such as silicon-containing halide silicon tetrachloride, trichlorosilane, dichlorodihydrogen silicon, silicon hexachloride, silane, disilane, hydrogen, and the like, a dopant gas such as boron trichloride, phosphine, and the like, and by-product gases of the reaction such as dichlorodihydrosilicon (in a case in which the precursor is not dichlorodihydrosilicon), hydrogen chloride, and the like. The collected tail gas is passed into a separation device for separation to obtain unreacted precursors and by-products. If the quality of the unreacted precursors obtained from separation meets the requirements, the unreacted precursors are directly passed into the chemical vapor deposition device for recycling; if the quality does not meet the requirements, the unreacted precursors are used after further rectification. The hydrogen chloride obtained from separation can be reacted with silicon to synthesize trichlorosilane, and trichlorosilane is purified for use in the factory. High-value products such as dichlorodihydrosilicon can be sent out to be used as the precursors of the chip factory.

Because hydrogen chloride is a gas at a normal pressure and a normal temperature, and trichlorosilane has a boiling point of 35 degrees under a normal pressure, the energy consumption for separation and the energy consumption for rectification of trichlorosilane and hydrogen chloride are very low. Briefly, the cost of recovering hydrogen chloride and trichlorosilane can be approximately zero. Generally, in the cost structure of monocrystalline silicon chemical vapor deposition (including device depreciation), the cost of the precursor gas is about 25%-15%, when the conversion rate is 20% (the device and the process having a conversion rate of 40% are extremely rare), after the entire cycle of the separation and purification device, the precursor can be approximately recycled at a low cost, and the low cost is included in the cost of separation and purification, the cost of the precursor can still be reduced to about 5-8% of the total cost, that is, the total cost is reduced by 10%-18%.

A new porous silicon layer is etched on the striped monocrystalline silicon substrate, and a monocrystalline silicon thin film is grown thereon, is striped off again, so as to be repeatedly and cyclically used.

Due to the repeated etching of the porous silicon layer, the thickness of the monocrystalline silicon substrate decreases and becomes thinner after repeated cycles. When the thickness drops to a certain threshold, etching the porous silicon is stopped, and the chemical vapor deposition device is directly used to grow a monocrystalline silicon thin film on the monocrystalline silicon substrate until the thickness of the monocrystalline silicon substrate reaches a required threshold. Then, monocrystalline silicon wafers are continuously manufactured according to the above method. The threshold is a certain value between 100 microns and 2 mm, and different substrate sizes have different requirements for the lower threshold of the minimum substrate thickness. In this way, the monocrystalline silicon substrate below the lower threshold of thickness can be repeatedly and cyclically used.

According to the implementation of the present application, the cost of directly depositing a monocrystalline silicon thin film by chemical vapor deposition can be lower than that of Czochralski single crystal + slicing, and therefore the use of chemical vapor deposition to supplement the thickness of the monocrystalline silicon substrate not only allows the utilization of substrates whose thicknesses are below the lower threshold of the substrate thickness, but also the cost of supplementing the grown thin film is lower than the cost of single crystal pulling. Generally, a silicon wafer with a thickness of 750 microns is used as an initial monocrystalline silicon substrate, and the threshold is set to be decreased to 450 microns and then reproduction of the silicon wafer is started. Each time the monocrystalline silicon is produced, 3 microns are consumed for one side for a single time, 300 microns are consumed after 50 cycles, and the substrate becomes thicken by starting the chemical vapor deposition again. This is equivalent to that 3 microns of monocrystalline silicon is consumed in addition to its own thickness for each monocrystalline silicon wafer. If the 450-micron substrate is directly discarded without recycling, assuming that the 450-micro substrate is distributed to a total of 100 silicon wafers on both sides for 50 times, this indicates that the 4.5-micron-thick substrate is discarded for each wafer. This is equivalent to that a total of 3 microns + 4.5 microns = 7.5 microns silicon layer per monocrystalline silicon wafer is consumed each time. Assuming that the thickness of each monocrystalline silicon wafer is 80 microns, the cost of chemical vapor deposition can be reduced by 4.5 microns/(80+7.5) microns = 5.1%.

In the present application, the production capacity of directly producing monocrystalline silicon wafers by the chemical vapor deposition method is improved by comprehensively using the above method, and a process for manufacturing a silicon wafer is combined with a process of a diffusion emitter conventionally belonging to cell manufacturing, so that the manufacturing cost of the solar monocrystalline silicon cell is significantly reduced.
1. A monocrystalline silicon thin-film silicon wafer is simultaneously deposited on both sides on the monocrystalline silicon substrate, the capacity of the chemical vapor deposition device is doubled, and equipment investment costs are reduced by half.
2. Porous silicon is simultaneously etched on both sides on the monocrystalline silicon substrate, and the production costs of the porous silicon are reduced by half.
3. A monocrystalline rod is cut, and a rectangular double-sided monocrystalline silicon substrate is used, to obtain a monocrystalline silicon cell of silicon wafers having an area larger than the current 156-mm, 166-mm square silicon wafers or even larger than 210-mm square silicon wafers, such as 166mm × 4200mm. Because the cost of silicon wafers and cells has been reduced rapidly, and the cost of glass of the panel of the assembly has changed slowly, many technologies have been developed to reduce the cost of the assembly by sacrificing the cost of the silicon wafer cells to increase the power of the assembly. Silicon wafers having a larger area are expected to help reduce the cost of the process part of the cell manufacturing assembly.
4. In a case of double-sided deposition, a design without a graphite susceptor (or referred to as a carrier plate) is used. The amortization cost of each graphite susceptor of 1.3 US dollars is reduced. It ensures that the operating expense of a method for directly obtaining a silicon wafer by the chemical vapor deposition is lower than that of the technology route of polycrystalline material + crystal growth + slicing.
5. The monocrystalline silicon wafer is not striped from the monocrystalline silicon substrate on which the monocrystalline silicon thin film is deposited, and the polycrystalline silicon substrate integrally enters a cell device for a cell process. The two-step process of depositing the back mask and removing the mask can be omitted, so that the investment and cost of cell production can be reduced by about 10%.
6. An epitaxy emitter is further made by in-situ chemical vapor deposition, so that the investment in the cell device can be further reduced.
7. The investment of cleaning equipment for removing the cutting damage is reduced.
8. Porous silicon is used as the backside light trapping structure, so that the cell efficiency is further improved.
9. The tails gas from the chemical vapor deposition device is separated, purified, and recycled, so that the cost can be reduced by 10%-17%.
10. The chemical vapor deposition method is used to recycle the thinned substrate after the porous silicon is etched, so that the cost is further reduced by about 2.8-5.1%.

In the above ten aspects, except that, for the in-situ fabrication of the epitaxy emitter of the aspect 6, there is a literature reports that compared with the diffusion emitter, a passivation technology different from the mainstream passivation layer needs to be developed for the epitaxy emitter, the effect of texturing on the cell efficiency after the emitter fabrication is unknown. It can be confirmed through public literature that the productivity and effect are improved in others aspects 1-5, 7-10, and it can be directly confirmed that the present application has a huge improvement in cost productivity and efficiency. The combined contribution of these cost savings can be as high as 60-70% or more. In addition, calculated from the cost of polycrystalline silicon raw materials, the current price of the most high-end monocrystalline dense polycrystalline silicon raw materials suitable for Czochralski single crystal is 72,000-76,000 RMB per ton including tax (in the first half of 2019), the weight of the 156-mm 150-micron silicon wafer is about 8.5 grams, and the cost for per silicon wafer is about 0.646 RMB (about 0.1 US dollars) calculated based on that the cost of the polysilicon raw material is 76,000 RMB per ton (in the chemical vapor deposition, excluding various cutting edge losses and side wall losses). Because chemical vapor deposition monocrystalline silicon wafers use trichlorosilane and hydrogen as high-temperature precursors (different reactions, different by-products) like the Siemens-method polycrystalline silicon, after the most expensive consumable that is graphite susceptor (carrier plate) is canceled, and after all precursors and by-products are recycled in a closed-loop, it can be considered that the monocrystalline silicon wafer of 8.5 grams by direct deposition should cost the same as the polycrystalline silicon of 8.5 grams by the Siemens method. The difference in cost mainly comes from the polycrystalline silicon, and due to the larger capacity of the reduction furnace, the polysilicon silicon has less heat loss to the outside world at high temperatures (Note: An important part of the cost reduction technology approach of Siemens-method polycrystalline silicon comes from the decreasing in the reduction power consumption brought by the larger reduction furnace and the higher single-furnace production capacity. In the past 15 years, the production capacity of the domestic reduction furnace has improved from 12 pairs of rods to 64 pairs of rods, and the reduction power consumption has decreased from 100-200 kWh per kilogram down to 35-45 kWh per kilogram). If a price twice the price of Siemens-method polycrystalline silicon of 8.5 grams is used to cover all possible cost factors that cause the cost of the monocrystalline silicon wafer obtained by the chemical vapor deposition to be higher than the cost of the polycrystalline silicon obtained by a Siemens method, the cost of manufacturing a monocrystalline silicon wafer by direct chemical vapor deposition method should be less than two times of (0.646 RMB, about 0.1 US dollars), that is, 1.29 RMB that is less than 0.2 US dollars according to the current exchange rate, which already includes the profit and value-added tax of the manufacturer. Generally, the cost of a silicon wafer is considered as the sum of the silicon cost of the polycrystalline silicon material and the non-silicon cost (crystal pulling and slicing). The cost structure of the monocrystalline silicon wafer is shown in the table below:

**Table 3**

| Monocrystalline silicon wafer cost calculation (non-silicon cost +silicon cost) | | | | | |
|---|---|---|---|---|---|
| Thickness of a monocrystalline silicon wafer (micrometer) | 190 | 170 | 150 | 130 | 110 |
| Price of a silicon material (US dollars per | US $ 10.00 | US $ 10.00 | US $ 10.00 | US $ 10.00 | US $ 10.00 |
| kilogram) | | | | | |
| Manufacturing cost of ta crystal rod (RMB/kilogram) | ¥ 80.00 | ¥ 80.00 | ¥ 80.00 | ¥ 80.00 | ¥ 80.00 |
| Idler groove pitch (micrometer) | 293 | 273 | 253 | 233 | 213 |
| Theoretical wafer quantity (wafer per kilogram) | 60.3 | 64.7 | 69.8 | 75.8 | 83 |
| Pass rate % | 95 | 95 | 95 | 95 | 95 |
| Actual production (wafer per kilogram) | 57.3 | 61.5 | 66.3 | 72.0 | 78.9 |
| Silicon consumption per wafer (gram) | 17.46 | 16.27 | 15.08 | 13.89 | 12.68 |
| Silicon cost per wafer (RMB/wafer) | ¥ 1.25 | ¥ 1.17 | ¥ 1.08 | ¥ 1.00 | ¥ 0.91 |
| Non-silicon cost (crystal pulling and slicing)/per wafer | ¥ 1.40 | ¥ 1.30 | ¥ 1.21 | ¥ 1.11 | ¥ 1.01 |
| Silicon cost per wafer (total) | ¥ 2.65 | ¥ 2.47 | ¥ 2.29 | ¥ 2.11 | ¥ 1.92 |

It can be learned that, due to the side wall removal and the cutting edge loss, the silicon cost of a monocrystalline silicon wafer is approximately twice the silicon cost corresponding to the weight of one silicon wafer. That is, the cost of directly producing a monocrystalline silicon wafer by chemical vapor deposition is comparable to the silicon cost of the conventional silicon wafer, which completely reduces all non-silicon costs. In 2019, the quotation of monocrystalline P-type 156-mm 180-µm from mainstream monocrystalline silicon wafer manufacturers is ¥ 3.07, and therefore this method has a very high cost potential. It is known that silicon wafers having a thickness of 80-120 micrometers are still suitable for the current mainstream cell structure, and there is no great loss of efficiency. If the chemical vapor deposition method is used to directly produce a monocrystalline silicon wafer having a thickness of 80 micrometers, because the deposition thickness of the monocrystalline silicon thin film on the porous silicon is halved relative to the thickness of 150 micrometers, it is expected to achieve a selling price of 0.1 US dollars per 156-mm monocrystalline silicon wafer. Such a thickness of silicon wafer cannot be implemented by the route of polycrystalline silicon-single crystal pulling-slicing method in the short term. Therefore, the monocrystalline silicon wafer produced by chemical vapor deposition by using this method has very strong market competitiveness.

Numerous specific details are described in the specification provided herein. However, it can be understood that the embodiments of the present application may be practiced without these specific details. In some instances, well-known methods, structures and techniques have not been shown in detail in order not to obscure an understanding of this description.

Similarly, it should be understood that, to streamline this disclosure and help understand one or more of the various aspects of the invention, in the above descriptions of embodiments of the present invention made for illustration purposes, various features of the present invention are sometimes grouped into a single embodiment, a drawing, or their respective descriptions. However, a way of disclosing should not be interpreted as reflecting the following intention: the contemplated present invention requires more features than those clearly disclosed in each claim. More accurately, as reflected in the claims below, the aspects of invention are less than all features of a single embodiment that is previously disclosed. Therefore, the claims that follow a specific implementation manner definitely incorporate the specific implementation manner. Each claim serves as a separate embodiment of the present invention.

Persons skilled in the art may understand that modules in devices in the embodiments may be adaptively changed and be disposed in one or more devices that are different from those of these embodiments. Modules or units or components in the embodiments may be combined into a module or a unit or a component, and additionally, may be divided into a plurality of submodules or subunits or subcomponents. Except a fact that at least some of these features and/or processes or units are mutually exclusive, all disclosed features and all processes or units of any method or device that are disclosed in such a way in this specification (including the appended claims, the abstract, and the accompanying drawings) may be combined in any combination mode. Unless otherwise explicitly stated, each feature disclosed in this specification (including the appended claims, the abstract, and the accompanying drawings) may be replaced by an alternative feature that serves same, equivalent, or similar purposes.

In addition, persons skilled in the art can understand that, although some embodiments described herein include some features included in another embodiment instead of including another feature, a combination of features of different embodiments means falling within the scope of the present invention and forming different embodiments. For example, in the following claims, any one of the contemplated embodiments may be used in any combination mode.

The word "comprising" does not exclude the presence of elements or steps not listed in a claim. The word "a" or "an" preceding an element does not exclude the presence of a plurality of such elements. The present application can be implemented by means of hardware including several different elements and by means of a suitably programmed terminal device. In a unit claim enumerating several terminal devices, several of these terminal devices can be embodied by the same hardware. The use of the words first, second, and third, etc. do not denote any order. These words can be interpreted as names.

## Claims

1. A method for manufacturing a monocrystalline silicon sheet, comprising:
cutting a monocrystalline silicon rod along a radial or an axial direction of the monocrystalline silicon rod to obtain a monocrystalline silicon substrate;
etching a porous silicon structure on a top surface and a bottom surface of the monocrystalline silicon substrate by wet etching;
depositing a monocrystalline silicon thin layer on the porous silicon structure by chemical vapor deposition, so that a thickness of the monocrystalline silicon thin layer reaches a predetermined value; and
striping the monocrystalline silicon thin layer from the porous silicon structure to obtain the monocrystalline silicon sheet.

2. The manufacturing method according to claim 1, wherein the etching a porous silicon structure on a top surface and a bottom surface of the monocrystalline silicon substrate by wet etching further comprises:
disposing a pair of negative electrodes on the top surface and the bottom surface of the monocrystalline silicon substrate, respectively, applying a current, and etching the porous silicon structure on the top surface and the bottom surface.

3. The manufacturing method according to claim 2, wherein the depositing a monocrystalline silicon thin layer on the porous silicon structure by chemical vapor deposition further comprises:
disposing the monocrystalline silicon substrate on a bracket in a reaction chamber for the chemical vapor deposition, heating the monocrystalline silicon substrate, and introducing a precursor gas into the reaction chamber, to make the precursor gas contact the porous silicon structure on the top surface and the bottom surface, so that the monocrystalline silicon thin layer is deposited on the porous silicon structure.

4. The manufacturing method according to claim 1, wherein the striping the monocrystalline silicon thin layer from the porous silicon structure to obtain the monocrystalline silicon sheet further comprises:
before striping the monocrystalline silicon thin layer, truncating the monocrystalline silicon thin layer to the porous silicon structure according to a required size of the monocrystalline silicon sheet, and striping the truncated monocrystalline silicon thin layer to obtain the monocrystalline silicon sheet; or
striping the monocrystalline silicon thin layer from the porous silicon structure, and truncating the striped monocrystalline silicon thin layer according to a required size of the monocrystalline silicon sheet, to obtain the monocrystalline silicon sheet.

5. The manufacturing method according to claim 3, wherein before striping the monocrystalline silicon thin layer, the method further comprises: placing the monocrystalline silicon substrate into a solar cell processing device, wherein the monocrystalline silicon thin layer is deposited on the top surface and the bottom surface of the monocrystalline silicon substrate, and performing a single-side preparation process of a solar cell on each of the monocrystalline silicon thin layers.

6. The manufacturing method of claim 1, wherein the method further comprises:
when the chemical vapor deposition is performed, collecting a tail gas from a chemical vapor deposition reaction, wherein the tail gas comprises a precursor gas and a dopant gas that do not participate in the reaction, and a by-product gas of the reaction;
separating the collected tail gas by using a separation apparatus to obtain the precursor gas that does not participate in the reaction and the by-product gas of the reaction; and
applying the precursor gas that does not participate in the reaction obtained from separation to the chemical vapor deposition, and/or applying the precursor gas synthesized by using the by-product gas obtained from separation as a raw material to the chemical vapor deposition.

7. The manufacturing method according to claim 1, wherein the method further comprises:
after striping the monocrystalline silicon thin layer from the porous silicon structure, etching the porous silicon structure on the top surface and the bottom surface of the monocrystalline silicon substrate by wet etching;
depositing a monocrystalline silicon thin layer on the porous silicon structure by chemical vapor deposition, so that a thickness of the monocrystalline silicon thin layer reaches a predetermined value; and
striping the monocrystalline silicon thin layer from the porous silicon structure to obtain the monocrystalline silicon sheet.

8. The manufacturing method according to claim 7, wherein the method further comprises:
when a thickness of the monocrystalline silicon substrate drops to a lower threshold, increasing the thickness of the monocrystalline silicon substrate by stopping etching the porous silicon structure and depositing the monocrystalline silicon thin layer on the crystalline silicon substrate.

9. The manufacturing method according to any one of claims 1-8, wherein the monocrystalline silicon thin layer has a width of 50 mm to 500 mm, a length of 50 mm to 5 m, and a thickness of 10µm to 10 mm.
